# EUROPEAN PATENT SPECIFICATION

(11) **EP 0 286 390 B1**
(45) Date of publication and mention of the grant of the patent: **20.10.1993**
(21) Application number: 88303080.1
(22) Date of filing: 06.04.1988
(51) Int. Cl.: H03F 3/60

(54) **Microwave power combining FET amplifier**
FET-Verstärker zur Kombinierung von Mikrowellenleistung
Amplificateur micro-ondes à FET à combinaison de puissance

(30) Priority: 10.04.1987 JP 87954/87
(43) Date of publication of application: 12.10.1988
(73) Proprietor: MITSUBISHI DENKI KABUSHIKI KAISHA, Tokyo 100 (JP)
(72) Inventor: Takagi, Tadashi Mitsubishi Denki Kabushiki Kaisha, Kamakura-shi Kanagawa (JP); Seino, Kiyoharu Mitsubishi Denki Kabushiki Kaisha, Kamakura-shi Kanagawa (JP); Takeda, Fumio Mitsubishi Denki Kabushiki Kaisha, Kamakura-shi Kanagawa (JP)
(74) Representative: Hackett, Sean James

(56) References cited:
- DE-A- 3 324 540
- US-A- 3 963 993
- MICROWAVE JOURNAL, vol. 25, no. 3, March 1982, pages 51,52,54,56,58,60,62,64,66, Dedham, Mass., US; J.M. SCHELLENBERG et al.: "A new approach to FET power amplifiers"
- IDEM
- IEEE INTERNATIONAL ELECTRON DEVICE MEETING 1979, TECHNICAL DIGEST, Washington, DC, 3rd-5th December 1979, pages 266-268, IEEE, New York, US; "A monolithic GaAs X-band power amplifier"

## Description

### BACKGROUND OF THE INVENTION

### Field of the Invention

The present invention relates to a microwave power combining FET amplifier for amplifying and combining power of microwave by using a microwave integrated circuit.

### Description of the Prior Art

The prior art of this type is disclosed, for example, in T. Takagi, et al, " A 1.5 Watt 28 GHz Band FET Amplifier", 1984 IEEE MTT-S Digest, pp. 227 ∼ 228, and in S.D. Bingham, et al, " A Miniaturized 6.5 ∼ 16 GHz Monolithic Power Amplifier Module", IEEE 1985 Microwave and Millimeter-Wave Monolithic Circuits Symp. Digest, pp. 38 ∼ 41. The former uses two two-stage amplifiers operated in parallel to each other and branch-line couplers for combining power/ splitting, and the latter uses four monolithic two-stage amplifiers operated in parallel to each other and inter-digital couplers for combining power/splitting.

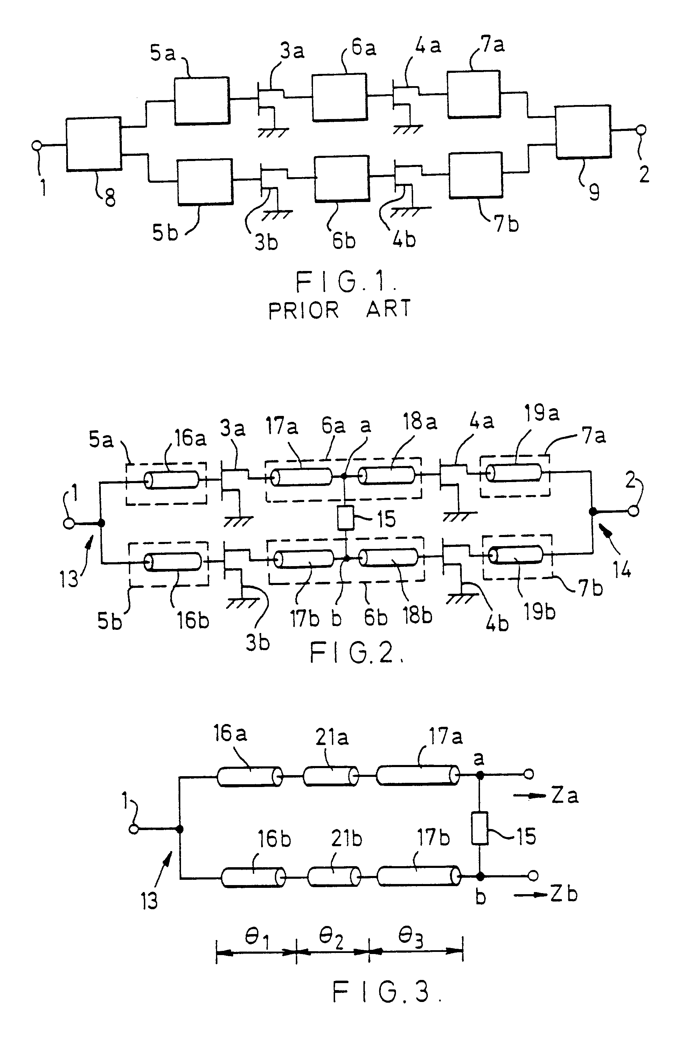

Fig.1 is a circuit diagram of a prior art microwave power combining FET amplifier shown, for example, in the above-mentioned 1984 IEEE MTT-S Digest, pp 227 ∼ 228, " A 1.5 Watt 28 GHz Band FET Amplifier". In the Figure, numeral 1 designates an input terminal, 2 an output terminal, 3a and 3b pre-stage FETs, 4a and 4b post-stage FETs, 5a and 5b input matching circuits, 6a and 6b interstage matching circuits, 7a and 7b output matching circuits, 8 a power splitter, and 9 a power combiner. The power splitter 8 and power combiner 9 in Fig.1 use branch-line type couplers or Wilkinson type couplers.

Next, the operation will be described. The microwave power inputted from the input terminal 1 is split by the power splitter 8, and one of the split microwave power is supplied to the power combiner 9 through the input matching circuit 5a, pre-stage FET 3a, interstage matching circuit 6a, post-stage FET 4a, and output matching circuit 7a. The other of the split microwave power is also suplied to the power combiner 9 through the input matching circuit 5b, pre-stage FET 3b, interstage matching circuit 6b, post-stage FET 4b, and output matching circuit 7b. The split two microwave powers are matched respectively by the input matching circuits 5a, 5b, interstage matching circuits 6a, 6b, and output matching circuits 7a, 7b, and at the same time amplified by the FETs 3a, 3b, 4a, and 4b. The two microwave powers supplied to the power combiner 9 are combined, and amplified and combined microwave power is outputted from the output terminal 2.

The power splitter 8 and power combiner 9 have in the inside thereof resistance circuits for isolation, and the resistance circuits for isolation serve to absorb the microwave power which propagates in a propagation mode of odd mode due to microwaves having equal amplitude and opposite phases caused by non-uniformity of characteristics of individual FETs 3a, 3b, 4a, and 4b. As a result, the amplifier arranged as shown in Fig.1 can be operated stably.

However, as described above, in the prior art amplifier, in order to eliminate the influence of reflection of the microwave due to the non-uniformity of the characteristics of the FETs, it is necessary to provide the resistance circuits for isolation in the inside of the power splitter and the power combiner. For the purpose of providing these resistance circuits for isolation, a branch-line type coupler or a Wilkinson type coupler having such a resistance circuit is required separately. As a result, there has been a problem in that the structure of the amplifier is complicated and it is difficult to make the shape small in size.

German Patent specification DE 3 324 540 discloses a microwave amplifier having a pair of multi-stage FET amplifiers in parallel to each other. The multi-stage amplifiers include input/output circuits which are connected by means of 3 dB couplers.

Microwave Journal, vol. 25, No. 3, March 1982, pages 51, 52, 54, 56, 58, 60, 62, 64 and 66, Dedham, Mass. U.S.; J.M. Schellenberg et al. entitled: "A new approach to FET power amplifiers" relates to a FET cell combiner having a number of one stage amplifiers connected in parallel. The input and output circuit of each of the one stage amplifiers comprises a distributed constant circuit and an isolation resistance, to terminate the odd modes.

### SUMMARY OF THE INVENTION

The present invention was made to solve the above problem, and it is an object of the invention to provide a microwave power combining FET amplifier without including a power splitting circuit and a power combining circuit which employ a branch-line type coupler or a Wilkinson type coupler, and yet performing equivalent function to these circuits thereby enabling to arrange in a simple structure and in a small size.

According to the present invention, there is provided a microwave power combining FET amplifier including a plurality of multistage FET amplifiers connected in parallel to each other, each of said multistage FET amplifiers having an input matching circuit, an output matching circuit, and an interstage matching circuit, each of said circuits being formed by a microwave integrated circuit, the plurality of interstage circuits being provided respectively corresponding to said plurality of multistage FET amplifiers; further having a pair of T-type branch circuits respectively for power splitting and for power combining; and a resistance circuit having a predetermined resistance value connected between predetermined positions (a,b) opposing to each other respectively at said plurality of interstage matching cirucits.

### BRIEF DESCRIPTION OF THE DRAWINGS

Fig.1 is a circuit diagram of a prior art microwave power combining FET amplifier;
Fig.2 is a circuit diagram showing a first embodiment of the present invention;
Fig.3 is a circuit diagram for explaining the principles of operation of the first embodiment;
Fig.4 is a circuit diagram showing a second embodiment of the invention;
Fig.5 is a circuit diagram showing a third embodiment of the invention; and
Fig.6 is a circuit diagram showing a fourth embodiment of the invention.

### DESCRIPTION OF THE PREFERRED EMBODIMENTS

The embodiments of the present invention will be described with reference to the drawings. Fig.2 is a circuit diagram of a microwave power combining FET amplifier according to a first embodiment of the invention. In Fig.2, identical reference numerals are used to refer to corresponding elements in Fig.1, and descriptions thereof are omitted.

In Fig.2, input matching circuits 5a and 5b are constituted by distributed constant transmission lines 16a and 16b respectively, and interstage matching circuits 6a and 6b are respectively constituted by pairs of distributed constant transmission lines 17a, 18a, and 17b, 18b. Furthermore, output matching circuits 7a and 7b are constituted by distributed constant transmission lines 19a and 19b. Between an input terminal 1 and the input matching circuits 5a, 5b, there is provided a T-type branch circuit 13 for performing power splitting, and a T-type branch circuit 14 is provided between an output terminal 2 and the output matching circuits 7a, 7b for performing power combining. The interstage matching circuits 6a and 6b are provided respectively corresponding to a plurality of FETs (multi-stage FET amplifier) 3a and 4a and a plurality of FETs 3b and 4b, and a resistance circuit 15 having a predetermined resistance value is connected between predetermined positions a and b opposing to each other and respectively in the interstage matching circuits 6a and 6b. In this respect, in a microwave integrated circuit, the distributed constant transmission lines 16a, 16b, 17a, 17b, 18a, 18b, 19a, and 19b are formed by microstrip lines ( line having a single conductor strip disposed in parallel and close to a flat metalic plate).

Next, the operation in the first embodiment will be described. The microwave power inputted from the input terminal 1 is split by the T-type branch circuit 13. One of the split microwave power is supplied to the T-type branch circuit 14 through the input matching circuit 5a, pre-stage FET 3a, interstage matching circuit 6a, post-stage FET 4a, and output matching circuit 7a. The other of the split microwave power is supplied to the T-type branch circuit 14 through the input matching circuit 5b, pre-stage FET 3b, interstage matching circuit 6b, post-stage FET 4b, and output matching circuit 7b. Both the microwave powers split by the T-type branch circuit 13 are respectively amplified by the FETs 3a and 4a and the FETs 3b and 4b, and are combined by the T-type branch circuit 14. Accodingly, the amplified and power combined microwave power is outputted.

When there are non-uniformities in the characteristics of the FETs 3a, 3b, 4a, and 4b, the amplitudes and phases of the two microwaves which reach the T-type branch circuit 14 differ from each other. Generally, there are two types of transmission modes of wave, that is, an odd mode in which the amplitudes of two waves are equal and the phases are opposite to each, and an even mode in which the amplitudes and phases of the two waves are equal to each other. Two input microwaves having the same amplitude and phase and propagating in the even propagation mode are combined in the T-type branch circuit 14 and delivered to the output terminal 2. However, two input microwaves having the same amplitude and opposite phases and propagating in the odd propagation mode are reflected at the T-type branch circuit 14. The reflected microwaves propagate in the direction of the T-type branch circuit 13 at the input side, and they are again reflected from the T-type branch circuit 13. Ultimately, multiple reflection is repeated between the T-type branch circuit 13 and the T-type branch circuit 14, and the amplification characteristic is affected adversely. For this reason, in the first embodiment, predetermined positions a and b opposing to each other respectively at the interstage matching circuits 6a and 6b are connected by a resistance circuit 15 to each other to eliminate the influence of the above-mentioned multiple reflection.

The operation of the arrangement will be described. In order to realize a high output microwave power combining FET amplifier, FETs having a large gate width and a high output level are used in the post-stage FETs 4a and 4b as compared with the pre-stage FETs 3a and 3b. Generally, since the FETs having a large gate width are apt to exhibit large non-uniformities in the characteristic of the FETs, the non-uniformities in the characteristic tend to become large in the post-stage FETs 4a and 4b as compared with the pre-stage FETs 3a and 3b. Accordingly, here it is supposed that approximately, the pre-stage FETs 3a and 3b have no non-uniformities in the characteristic therebetween, and the post-stage FETs 4a and 4b have non-uniformities in the characteristic therebetween.

Fig.3 is a circuit diagram for explaining the principles of operation when the non-uniformities in the characteristic are present in only the post-stage FETs 4a and 4b. In Fig.3, distributed constant transmission lines 21a and 21b represent the pre-stage FETs 3a and 3b by regarding them approximately as lines. Furthermore, in Fig.3, ϑ ₁ and ϑ ₃ are respectively electrical angles due to the distributed constant transmission lines 16a, 16b, and the distributed constant transmission lines 17a and 17b, and ϑ ₂ is an electrical angle which is given by the relationship

$\text{ϑ ₂ ≈ S ₁₂ ≈ S ₂₁}$

among S parameters of the pre-stage FETs 3a and 3b. Here, S₁₂ and S₂₁ are elements S₁₂ and S₂₁ of a so-called 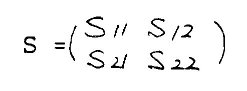
Further, Za and Zb are impedances as viewed the sides of the post-stage FETs 4a and 4b from the points a and b. Numeral 15 designates a resistance circuit having an impedance Z.

Here, the relationships among the electrical angles ϑ ₁, ϑ ₂, and ϑ ₃, and the relationships among the impedances Za, Zb, and Zc are expressed by

$\text{ϑ ₁ + ϑ ₂ + ϑ ₃ ≈ 9 0° (1)}$

$\text{Z/2 ≈ Za* ≈ Zb* (2)}$

Where, Za* and Zb* in the formula (2) represent conjugate complexes of Za and Zb.

As will be seen from the relationships in the formulas (1) and (2), the circuit of Fig.3 can be regarded approximately as being equivalent to the Wilkinson type coupler. Accordingly, the microwave power having the same amplitude and opposite phases reflected due to the non-uniformities in the characteristic of the post-FETs 4a and 4b is consumed by the resistance circuit 15 according to the principles of operation similar to that of the Wilkinson type coupler. In other words, when the microwave power split by the T-type branch circuit 13 reaches the T-type branch circuit 14, it is reflected with the same amplitude and opposite phases towards the input side, and due to this reflection, a potential difference is developed across the resistance circuit 15, and the reflected microwave power is fed to the resistance circuit 15 and consumed therein. In this case, if the non-uniformities in the characteristic are not present in the FETs, even when the resistance circuit 15 is provided, since the voltages applied to both ends of the resistance circuit 15 are equal to each other, no current flows through the resistance circuit 15. Therefore, the resistance circuit 15 does not affect the propagation mode in the even mode which contributes to the amplification characteristic, and the resistance circuit 15 functions as an absorbing circuit for the microwave power propagating in the propagation mode of the odd mode which is a cause of the multiple reflection.

In accordance with the first embodiment described above, it is possible to perform the power splitting or power combining by the T-type branch circuit, and at the same time, it is possible to absorb by the resistance circuit provided at a predetermined position in the interstage matching circuit, the microwave power propagating in the propagation mode of the odd mode due to the non-uniformities in the characteristic of the FETs. By virtue of this, it is possible to prevent the adverse effect on the amplification characteristic and to prevent the unstable operation such as oscillation due to the multiple reflection. Accordingly, in the first embodiment, the power splitter and power combiner using the branch-type or Wilkinson type couples employed in the prior art amplifiers of this kind are not particulary necessary, and the structure can be simplified and the shape can be made small in size.

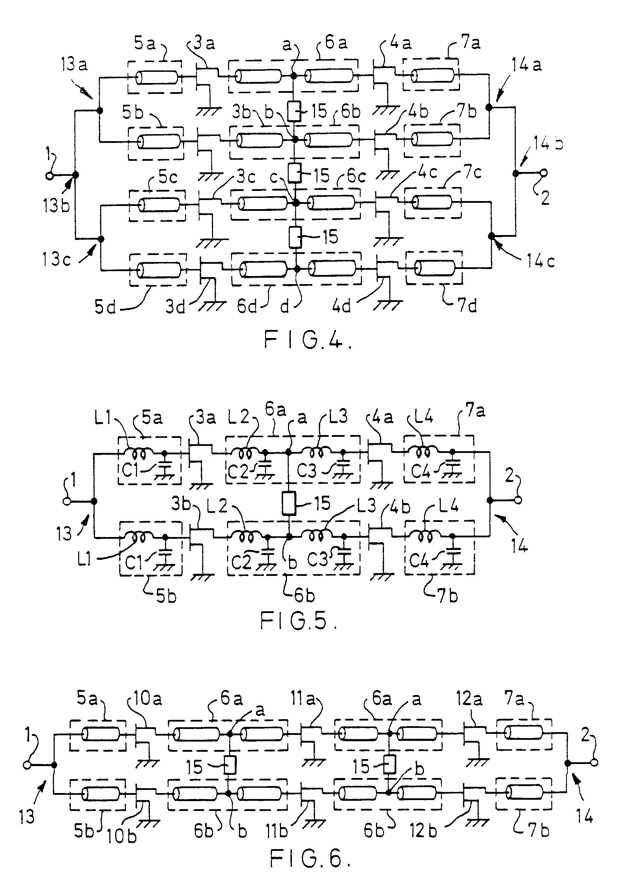

Fig.4 is a circuit diagram showing a second embodiment of the present invention. In the second embodiment, four multistage FET amplifiers are used, and corresponding constituent parts to that shown in Fig.2 are designated with identical reference numerals. In Fig.4, numerals 3c and 3d designate pre-stage FETs, 4c and 4d post-stage FETs, 5c and 5d input matching circuits, 6c and 6d interstage matching circuits, 7c and 7d output matching circuits, and 13a, 13b, 13c, 14a, 14b, and 14c designate T-type branch circuits. The operation in this second embodiment is the same as the first embodiment, and the description thereof is omitted. Furthermore, in this embodiment, three or five multistage FET amplifiers or more may be used.

Fig.5 is a circuit diagram showing a third embodiment. The characteristic features in the third embodiment reside in that each of input matching circuits 5a and 5b is formed by a coil L1 and a capacitor C1, each of interstage matching circuits 6a and 6b is formed by coils L2, L3, and capacitors C2, C3, and each of output matching circuits 7a and 7b is formed by a coil L4 and a capacitor C4. In other words, the input matching circuits 5a and 5b, interstage matching circuits 6a and 6b, and output matching circuits 7a and 7b are formed by concentrated constant circuit elements. In the case of the third embodiment, the same operation can be performed as in the first embodiment.

Fig.6 is a circuit diagram showing a fourth embodiment of the present invention. In Fig.6, the constituent elements corresponding to that in Fig.2 are designated by identical reference numerals and the description thereof is omitted. In the fourth embodiment, two three-stage FET amplifiers are used, and numerals 10a and 10b designate respectively pre-stage FETs, 11a and 11b designate intermediate stage FETs, and 12a and 12b designate post-stage FETs. In the forth embodiment, also the operation is the same as in the first embodiment. This embodiment may be formed by four stages or more FETs.

Furthermore, the present invention may be applied to a monolithic integrared circuit, and a plurality of FETs, input matching circuits, output matching circuits, interstage matching circuits, T-type branch circuits, and resistance circuits may be formed on the same semiconductor substrate.

## Claims

1. A microwave power combining FET amplifier including a plurality of multistage FET amplifiers (3a,3b,4a,4b) connected in parallel to each other, each of said multistage FET amplifiers having an input matching circuit (5a,5b), an output matching circuit (7a,7b), and an interstage matching circuit (6a,6b), each of said circuits being formed by a microwave integrated circuit, the plurality of interstage circuits (6a,6b) being provided respectively corresponding to said plurality of multistage FET amplifiers (3a,3b,4a,4b);
further having a pair of T-type branch circuits (13,14) respectively for power splitting and for power combining;
characterized by:
a resistance circuit (15) having a predetermined resistance value connected between predetermined positions (a,b) opposing to each other respectively at opposing two of said interstage matching circuits (6a,6b) provided at opposing multistage FET amplifiers.

2. A microwave power combining FET amplifier according to claim 1 wherein said plurality of multistage FET amplifiers are formed by four FETs including two pre-stage FETs (3a,3b) connected in parallel to each other and two post-stage FETs (4a,4b) connected in parallel to each other.

3. A microwave power combining FET amplifier according to claim 1 wherein each of said input matching circuit (5a,5b), said interstage matching circuit (6a,6b), and said output matching circuit (7a,7b) is formed by a concentrated constant circuit element having a coil (L₁,L₂,L₃,L₄) and a capacitor (C₁,C₂,C₃,C₄).

4. A microwave power combining FET amplifier according to claim 1 wherein each of said pluraltiy of multistage FET amplifiers includes a pre-stage FET (10a,10b), an intermediate stage FET (11a,11b), and a post-stage FET (12a,12b), and said plurality of multistage FET amplifiers include two pre-stage FETs, two intermediate stage FETs, and two post-stage FETs respectively in parallel to each other.

5. A microwave power combining FET amplifier according to any one of claims 1 to 4 wherein said microwave power combining FET amplifier is formed by a monolithic intergrated circuit.

## Patentansprüche

1. Mikrowellenleistungskombinations-FET-Verstärker mit einer Vielzahl von parallelgeschalteten mehrstufigen FET-Verstärkern (3a, 3b, 4a, 4b), wobei jeder der mehrstufigen FET-Verstärker eine Eingangs-Anpassungsschaltung (5a, 5b), eine Ausgangs-Anpassungsschaltung (7a, 7b) und eine Zwischenstufen-Anpassungsschaltung (6a, 6b) aufweist und jede der Schaltungen durch eine integrierte Mikrowellenschaltung gebildet ist, wobei die Vielzahl von Zwischenstufen-Schaltungen (6a, 6b) jeweils der Vielzahl von mehrstufigen FET-Verstärkern (3a, 4b, 4a, 4b) entsprechend vorgesehen ist; weiterhin mit einem Paar von T-Abzweigschaltungen (13, 14) zur Leistungsteilung bzw. Leistungskombination;
gekennzeichnet durch
eine einen vorbestimmten Widerstandswert aufweisende Widerstandsschaltung (15), die zwischen vorbestimmte Stellen (a, b) geschaltet ist, welche einander jeweils an zwei einander gegenüberliegenden Zwischenstufen-Anpassungsschaltungen (6a, 6b) gegenüberliegen, die an einander gegenüberliegenden mehrstufigen FET-Verstärkern vorgesehen sind.

2. Mikrowellenleistungskombinations-FET-Verstärker nach Anspruch 1,
bei dem die Vielzahl von mehrstufigen FET-Verstärkern durch vier FETs gebildet ist, die zwei parallelgeschaltete Vorstufen-FETs (3a, 3b) und zwei parallelgeschaltete Nachstufen-FETs (4a, 4b) aufweisen.

3. Mikrowellenleistungskombinations-FET-Verstärker nach Anspruch 1,
bei dem jede Eingangs-Anpassungsschaltung (5a, 5b), jede Zwischenstufen-Anpassungsschaltung (6a, 6b) und jede Ausgangs-Anpassungsschaltung (7a, 7b) durch ein konzentriertes Konstant-Schaltungselement mit einer Spule (L₁, L₂, L₃, L₄) und einem Kondensator (C₁, C₂, C₃, C₄) gebildet ist.

4. Mikrowellenleistungskombinations-FET-Verstärker nach Anspruch 1,
bei dem jeder aus der Vielzahl von mehrstufigen FET-Verstärkern einen Vorstufen-FET (10a, 10b), einen Zwischenstufen-FET (11a, 11b) und einen Nachstufen-FET (12a, 12b) aufweist und die Vielzahl von mehrstufigen FET-Verstärker zwei Vorstufen-FETs, zwei Zwischenstufen-FETs und zwei Nachstufen-FETs jeweils parallel zueinander aufweist.

5. Mikrowellenleistungskombinations-FET-Verstärker nach einem der Ansprüche 1 bis 4,
bei dem der Mikrowellenleistungskombinations-FET-Verstärker durch eine monolithische integrierte Schaltung gebildet ist.

## Revendications

1. Amplificateur micro-ondes à transistor à effet de champ (FET) à combinaison de puissance incluant une pluralité d'amplificateurs à FET multi-étages (3a, 3b, 4a, 4b) connectés en parallèle les uns aux autres, chacun des amplificateurs à FET multi-étages comportant un circuit d'adaptation d'entrée (5a, 5b), un circuit d'adaptation de sortie (7a, 7b) et un circuit d'adaptation inter-étage (6a, 6b), chacun desdits circuits étant formé par un circuit micro-ondes intégré,
la pluralité des circuits inter-étages (6a, 6b) étant prévue respectivement en correspondance avec ladite pluralité d'amplificateurs à FET multi-étages (3a, 3b, 4a, 4b) ;
comportant en outre une paire de circuits de branchement du type T (13, 14) prévus respectivement pour séparer la puissance et pour combiner la puissance,
caractérisé par un circuit de résistance (15) présentant une valeur de résistance prédéterminée connecté entre les positions prédéterminées (a, b) opposées l'une à l'autre respectivement au niveau de deux opposés desdits circuits d'adaptation inter-étage (6a, 6b) prévus au niveau des amplificateurs à FET multi-étages opposés.

2. Amplificateur micro-ondes à FET à combinaison de puissance selon la revendication 1, dans lequel ladite pluralité d'amplificateurs à FET multi-étages sont formés par quatre FET incluant deux FET de pré-étage (3a, 3b) connectés en parallèle l'un à l'autre et deux FET de post-étage (4a, 4b) connectés en parallèle l'un à l'autre.

3. Amplificateur micro-ondes à FET à combinaison de puissance selon la revendication 1, dans lequel chaque circuit pris parmi ledit circuit d'adaptation d'entrée (5a, 5b), ledit circuit d'adaptation inter-étage (6a, 6b) et ledit circuit d'adaptation de sortie (7a, 7b) est formé par un élément de circuit constant concentré comportant une bobine (L₁, L₂, L₃, L₄) et une capacité (C₁, C₂, C₃, C₄).

4. Amplificateur micro-ondes à FET à combinaison de puissance selon la revendication 1, dans lequel chacun de ladite pluralité d'amplificateurs à FET multi-étages inclut un FET de pré-étage (10a, 10b), un FET d'étage intermédiaire (11a, 11b) et un FET de post-étage (12a, 12b) et ladite pluralité d'amplificateurs à FET multi-étages inclut deux FET de pré-étage, deux FET d'étage intermédiaire et deux FET de post-étage respectivement connectés en parallèle les uns aux autres.

5. Amplificateur micro-ondes à FET à combinaison de puissance selon l'une quelconque des revendications 1 à 4, dans lequel ledit amplificateur micro-ondes à FET à combinaison de puissance est formé par un circuit intégré monolithique.
